# EUROPEAN PATENT APPLICATION

(11) **EP 2 381 751 A1**
(43) Date of publication of application: **26.10.2011**
(21) Application number: 11160918.6
(22) Date of filing: 01.04.2011
(51) Int. Cl.: H05K 3/36

(54) **Auxiliary board joining structure**

(30) Priority: 16.04.2010 JP 2010094935
(71) Applicant: Honda Motor Co., Ltd., Tokyo 107-8556 (JP)
(72) Inventor: Ogawa, Makoto, Saitama 351-0193 (JP); Ueno, Masanori, Saitama 351-0193 (JP)
(74) Representative: Prechtel, Jörg

(57) **Abstract**

The auxiliary board joining structure further includes a plurality of positioning holes (6) formed in the main board (1), a plurality of positioning pins (20) formed on the main board (1), wherein the plurality of positioning pins (20) extend through the corresponding positioning holes (6) so as to be oriented parallel to the axial direction of the joint pins (17). Each of the positioning pins (20) has a height regulating face (23) for regulating a distance that the positioning pins are extended through the corresponding positioning hole (6). Each of the positioning pins (20) is formed long enough to be extended through the corresponding positioning hole (6) before the joint pins (17) are extended through the corresponding through-holes (5), when the main board (1) and the auxiliary board (10) are engaged.

## Description

### Technical Field

The present invention relates to an auxiliary board joining structure, and more particularly, to an auxiliary board joining structure that is appropriate for soldering an auxiliary board, such as a power module, to the surface of a printed board, which serves as a main board.

### Background Art

Conventionally, as a method for mounting an auxiliary board, such as a power module, on a printed board serving as a main board, the following method has been known: in which a plurality of joint pins extending upward from the auxiliary board are extended through corresponding holes made in the printed board, and the leading ends of the joint pins extended through the holes are soldered to the printed board, thereby electrically and physically joining both the boards.

Patent Literature 1 discloses an auxiliary board joining structure in which a plurality of positioning pins of large diameter are provided on an auxiliary board independently of joint pins. In this auxiliary board joining structure, the joint pins are positioned by extending the positioning pins through the through-holes, thus facilitating the insertion of thin joint pins through a main board.

### Citation List

### Patent Literature

Patent Literature 1 Japanese Patent Application Laid-Open No. 2000-223621

### Summary of Invention

### Technical Problem

Incidentally, the main and auxiliary boards are finally fixed together by soldering the leading ends of joint pins piercing the main board. However, in order to obtain satisfactory solder shapes (i.e., solder fillets) at this time, it is preferable that the distance that the joint pins project from the main board be identical. In the technology described in Patent Literature 1, the positioning pins facilitate the insertion of the joint pins. However, making the projecting distances of the positioning pins identical requires a jig for regulating the gap between the main board and auxiliary board. In order to enhance soldering efficiency, therefore, further improvement is required.

Accordingly, an object of the present invention is to provide an auxiliary board joining structure that enables satisfactory joining with solder, by solving the problems of the conventional technology described above, thereby regulating the projecting distances of the joint pins of an auxiliary board from a main board.

### Solution to Problem

To achieve the above object, the present invention has a first feature in that an auxiliary board joining structure comprising: a main board (1), an auxiliary plate (10, 10a), a joint pin (17) extending upward from the auxiliary board (10, 10a), and a through-hole (5) for the joint pin (17) formed in the main board (1), wherein the main board (1) and auxiliary board (10, 10a) are electrically and physically joined using a through-hole mounting system in which the joint pin (17) is extended through the through-hole (5), thereby soldering the main board (1) and auxiliary board (10, 10a), the auxiliary board joining structure further comprising: a plurality of positioning holes (6, 6a) formed in one of the main board (1) and the auxiliary board (10, 10a); a plurality of positioning pins (20, 20a) formed on the other one of the main board (1) and the auxiliary board (10, 10a), wherein the plurality of positioning pins (20, 20a) extend through the corresponding positioning holes (6, 6a) so as to be oriented parallel to the axial direction of the joint pins (17), wherein each of the positioning pins (20, 20a) has a height regulating face (23, 23a) for regulating a distance that the positioning pin is extended through the corresponding positioning hole (6, 6a).

The present invention has a second feature in that each of the positioning pins (20, 20a) is formed long enough to be extended through the corresponding positioning hole (6, 6a) before the joint pins (17) are extended through the corresponding through-holes (5), when the main board (1) and the auxiliary board (10, 10a) are engaged.

The present invention has a third feature in that each of the positioning pins (20) has a large diameter portion (22, 22a) and a small-diameter portion (21, 21a) extending upward from an end face of the large-diameter portion, and wherein a step surface between the large diameter portion (22, 22a) and the small-diameter portion (21, 21a) serves as the height regulating face (23, 23a).

The present invention has a fourth feature in that the auxiliary board (10) includes a power module board (12) from which the joint pins (17) extend, and an outer frame (11) holding the power module board (12) via sealing resin (16); and wherein the positioning pin (20) is integrally formed on the outer frame (11).

### Advantageous Effects of Invention

According to the present invention having the first feature, a plurality of positioning holes formed in one of a main board and an auxiliary board; a plurality of positioning pins formed on the other one of the main board and the auxiliary board , wherein the plurality of positioning pins extend through the corresponding positioning holes so as to be oriented parallel to the axial direction of joint pins, wherein each of the positioning pins has a height regulating face for regulating a distance that the positioning pin is extended through the corresponding positioning hole. Therefore, the positioning pins become to be able to regulate the projecting distances of the joint pins of an auxiliary board from a main board. Accordingly, the positioning pins also regulate the projecting distances of the joint pins from the main board, eliminating the need to separately provide a member for positioning the joint pins and a member for regulating the projecting distances of the joint pins, and hence simplifying the component structure. In addition, when the joint pins are soldered, a stable fillet shape with stable quality can be obtained.

According to the present invention having the second feature, each of the positioning pins is formed long enough to be extended through the corresponding positioning hole before the joint pins are extended through the corresponding through-holes, when the main board and the auxiliary board are engaged. Accordingly, extending the positioning pins through the positioning holes before extending joint pins through the through-holes positions the joint pins before the positioning pins. This makes it easy to engage the main and auxiliary boards.

According to the present invention having the third feature, each of the positioning pins has a large diameter portion and a small-diameter portion extending upward from an end face of the large-diameter portion, and wherein a step surface between the large diameter portion and the small-diameter portion serves as the height regulating face. Accordingly, the height regulating face can be formed with the simple structure, thus improving productivity.

According to the present invention having the fourth feature, the auxiliary board includes a power module board from which the joint pins extend, and an outer frame holding the power module board via sealing resin; and wherein the positioning pin is integrally formed on the outer frame. Accordingly, the direction in which the positioning pins are oriented is identical to the direction in which the joint pins are oriented, thus making it easier to engage the main and auxiliary boards. In addition, changing only the shape of the outer frame allows a common power module board to be used with various printed boards.

### Brief Description of Drawings

FIG. 1 is a side view of a printed board according to a first embodiment of the present invention;
FIG. 2 is a side view of the printed board on which a surface-mounting device is mounted;
FIG. 3 is a side view of a power module according to the first embodiment of the present invention;
FIG. 4 is a perspective view of a power module;
FIG. 5 is a perspective view illustrating engagement of the power module and printed board;
FIG. 6 is a side view of the state in which the power module and printed board are soldered;
FIG. 7 is an enlarged view of the surroundings of each positioning pin shown in FIG. 6;
FIG. 8 is a flowchart illustrating a procedure for mounting the power module on the printed board; and
FIG. 9 is a side view of a printed board according to a second embodiment of the present invention.

### Description of Embodiments

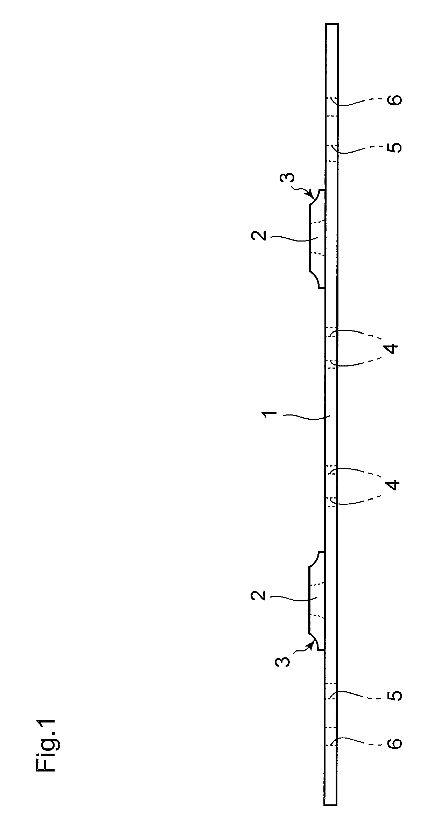

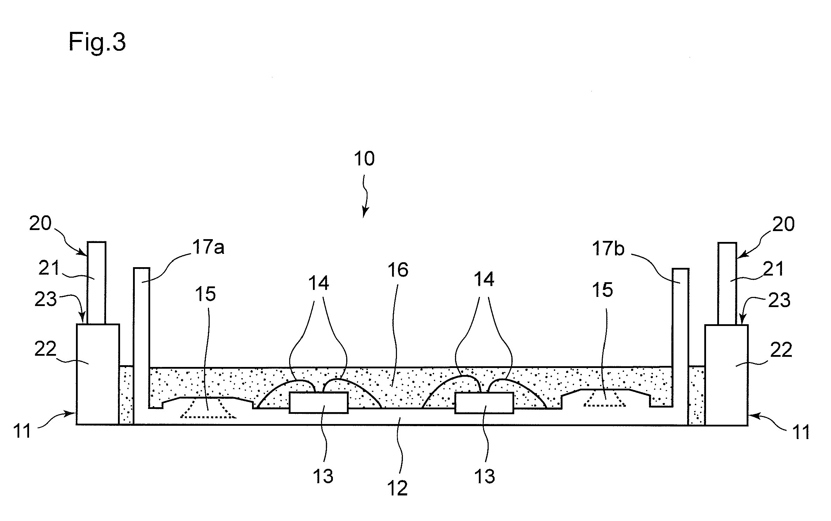

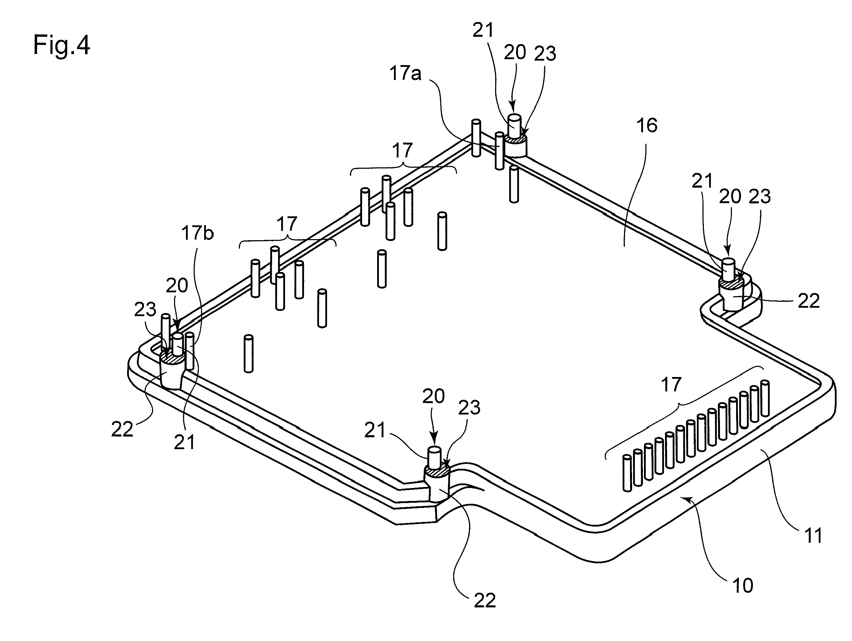

Preferred embodiments of the present invention will now be described in detail with reference to the drawings. FIG. 1 is a side view of a printed board 1, serving as a main board, according to a first embodiment of the present invention. An auxiliary board joining structure according to the present invention is used for regulating the distance that each of a plurality of joint pins extending upward from a power module 10 (see FIGS. 3 and 4), serving as an auxiliary board, projects upward (as viewed in the drawing) from the printed board 1 when the power module 10 is mounted on the printed board 1.

The printed board 1 includes: a plate-like member and a conductor pattern formed on the surface of the plate-like member, the plate-like member being formed, for example, by impregnating a cloth of laminated glass fiber with epoxy resin. Various electronic components are soldered to the surface of the conductor pattern. Examples of a method for mounting electronic components include a surface mounting method and a through-hole mounting method. In the surface mounting method, solder paste is applied to a printed board in advance, a device to be thus surface mounted (hereinafter referred to as surface mount device) such as a chip is mounted on the printed board, and then the solder is heated and melted in a high temperature furnace, thereby directly soldering and fixing the electronic component to the surface of the printed board. In the through-hole mounting method, a conductor, such as a lead wire or chip leg, is extended through a through-hole in the printed board, and the leading end of the conductor extended through the hole is soldered to the printed board, thereby fixing the electronic component.

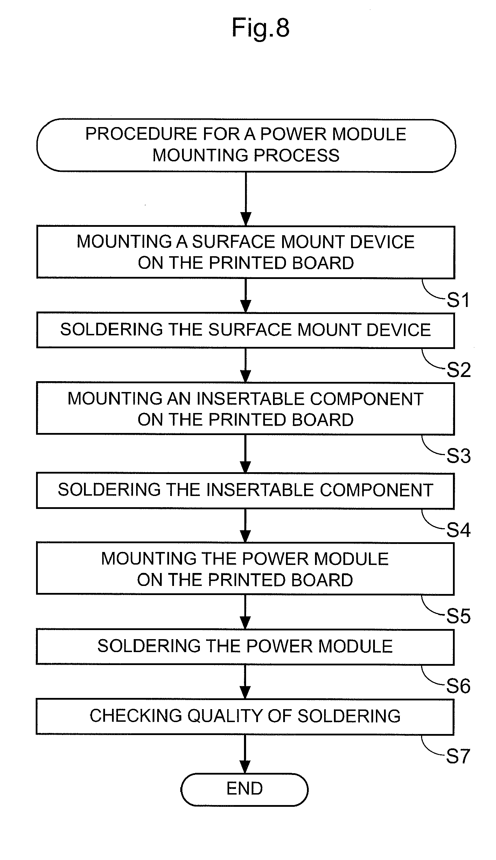

On the printed board 1, a surface mount device 2, such as a chip, is mounted using the surface mounting method. The surface mount device 2 is electrically and physically joined to the printed board 1 by a soldered leg portion 3. In addition to through-holes 4 and 5 for enabling the through-hole mounting method, a positioning hole 6 is formed in the printed board 1. Referring to the flowchart in FIG. 8 illustrating the procedure for a power module mounting process, the printed board 1 shown in FIG. 1 corresponds to the state obtained by completing step S1 (mounting a surface mount device on the printed board) and step S2 (soldering the surface mount device).

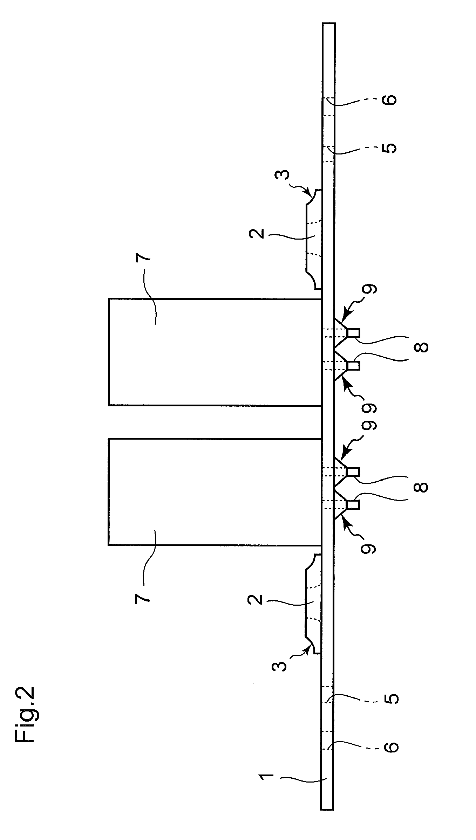

FIG. 2 is a side view showing the state in which two insertable components 7 are mounted on a printed board 1 using the through-hole mounting method. Reference numerals used in the description of the surface mounting system indicate portions identical or similar to those in the surface mounting method. Each insertable component 7 is fixed to the printed board 1 by extending each of two terminals 8 projecting from the lower part of this component through a through-hole 4, and then forming a solder fillet 9 on the back (the underside in the drawing) of the printed board 1. The state shown in FIG. 2 corresponds to the state obtained by completing step S3 (mounting an insertable component on the printed board) and step S4 (soldering the insertable component) in the flowchart in FIG. 8.

FIG. 3 is a side view of a power module 10 according the first embodiment of the present invention. FIG. 4 is a perspective view of the power module 10. The power module 10, serving as an auxiliary board, is configured by disposing a power module board 12 inside an outer frame 11 formed from rigid resin or the like, and then fixing the power module board 12 with sealing resin 16.

Disposed on the upper side of the power module board 12 for densely mounting power elements for the control of large currents are: power elements 13 connected by lead wires 14, and power elements 15 mounted on the surface. These electronic components are covered with the sealing resin 16, thereby protecting them from external factors such as light, heat, and humidity. Only a plurality of joint pins 17 for mounting the electronic components on the printed board 1 via through-holes project from the surface of the sealing resin 16. In the present embodiment, all the joint pins 17 are identical in shape and length, and also they project an identical distance from the sealing resin 16. In FIG. 3, only representative joint pins 17a and 17b, disposed adjacent to corresponding positioning pins 20, are shown.

The outer frame 11 of the power module 10 according to the present embodiment is provided with four positioning pins 20 for regulating the location where the power module 10 engages with the printed board 1, the positioning pins 20 being oriented parallel to the axial direction of the joint pins 17. Each positioning pin 20 has a small-diameter portion 21 extended through a corresponding positioning hole 6 formed in the printed board 1, and a large-diameter portion 22 greater than the small-diameter portion 21. The upper end of the large-diameter portion 22 has a height regulating face 23 (hatched in the drawing). In the present embodiment, all the positioning pins 20 are identical in shape and length and, additionally, their height regulating faces 23 are located in an identical plane.

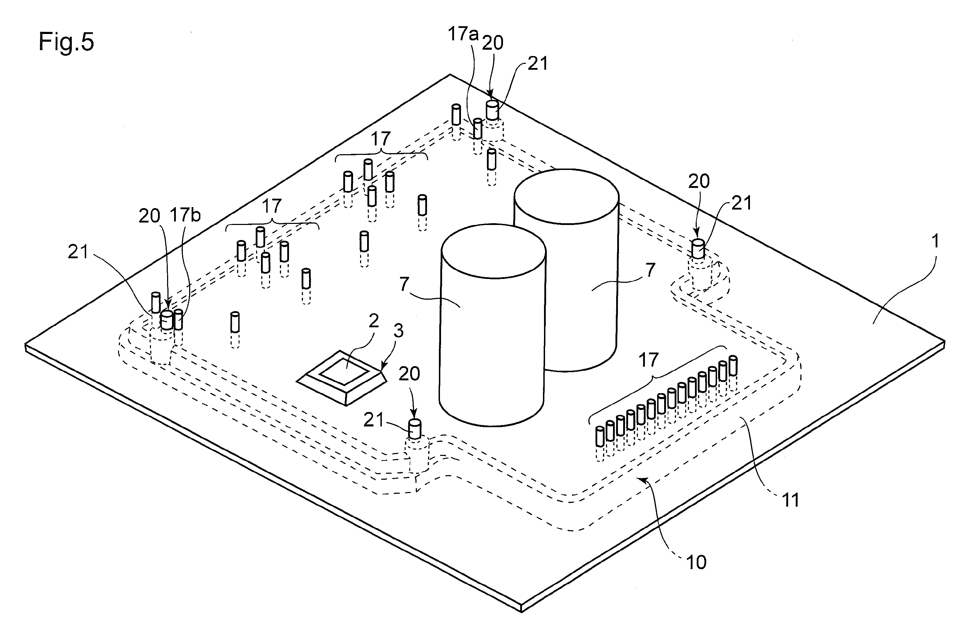

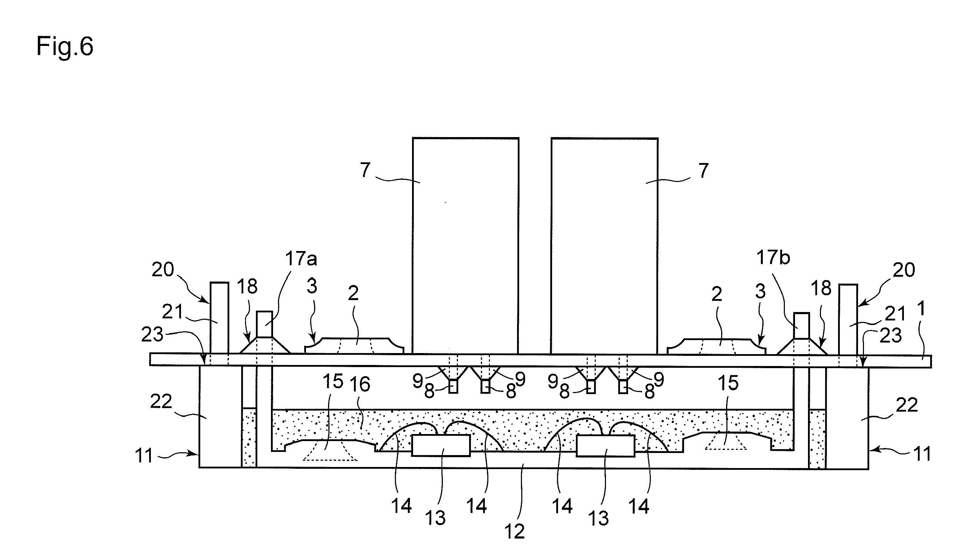

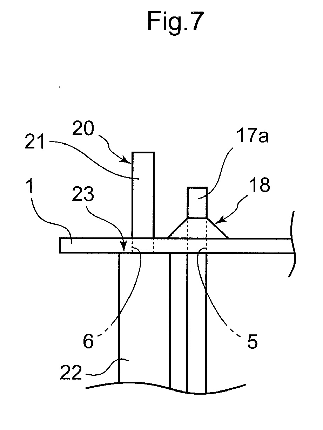

FIG. 5 is a perspective view illustrating the state in which the printed board 1 engages with the upper part of the power module 10. FIG. 6 is a side view showing the state in which the power module 10 and the printed board 1 are soldered. Reference numerals identical to those mentioned above indicate identical or similar portions. Further, FIG. 7 is an enlarged partial view of the surroundings of each positioning pin 20.

To engage the power module 10 and printed board 1 as shown in FIG. 5, the small-diameter portions 21 of the positioning pins 20 are passed through the corresponding holes 6 made in the printed board 1, thereby completing the positioning of the joint pins 17. The small-diameter portion 21 of each positioning pin 20 is thicker than the joint pins 17 and is formed long enough to be extended through the corresponding positioning hole 6 before the joint pins 17 are extended through the corresponding through-holes 5. Thus, the positioning pins 20 may easily be extended through the positioning holes 6.

As the small-diameter portion 21 is further inserted, the back (the underside in the drawing) of the printed board 1 comes into contact with the height regulating faces 23 of the positioning pins 20, thereby regulating the location of the printed board 1. Thus, the distance that the joint pins 17 project from the surface (the upper side in the drawing) of the printed board 1 are regulated so as to be identical. The state shown in FIG. 5 corresponds to the state obtained by completing step S5 (mounting the power module on the printed board) of the flowchart in FIG. 8.

Since the distance that the joint pins 17 project from the printed board 1 are regulated so as to be identical, as shown in FIG. 6, satisfactory uniform solder fillets 18 can easily be obtained without using a jig to fix the interval between the printed board 1 and the power module 10. The state shown in FIG. 6 corresponds to the state obtained by completing step S6 (soldering the power module) in the flowchart in FIG 8. After a soldering quality check is finished in step S7, the process of mounting the power module 10 on the printed board 1 terminates. In the soldering quality check, whether the shape of each solder fillet 18 relative to the projecting distance of the corresponding joint pin 17 is satisfactory can easily be determined visually, thus improving efficiency in work.

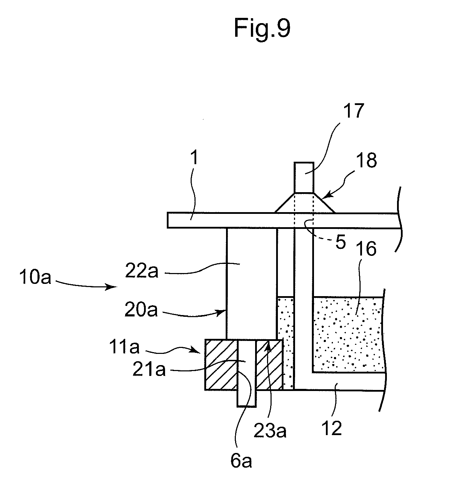

FIG. 9 is an enlarged partial side view of an auxiliary board joining structure according to a second embodiment of the present invention. Characteristic of this embodiment is that each positioning pin 20a, which has both the function of positioning a joint pin 17 and the function of regulating the distance that the joint pin 17 projects, is provided on the back (the underside in the drawing) of a printed board 1. Each positioning pin 20a has a small-diameter portion 21a extended through a positioning hole 6a formed in an outer frame 11a, and a large-diameter portion 22a, which is larger in diameter than the small-diameter portion 21a. A height regulating face 23a is formed at the lower end of the large-diameter portion 22. In this embodiment, this height regulating face 23a comes into contact with the back of the printed board 1, thereby regulating the distance that the joint pin 17 projects. This enables soldering with a solder fillet 18 that has stable quality.

As described above, in the auxiliary board joining structure of the present invention, the main board is provided with a plurality of positioning pins extended through the positioning holes in the main board so as to be oriented parallel to the axial direction of the joint pins and, in addition, each of these positioning pins has a height regulating face for regulating the distance that the positioning pin can be inserted into the corresponding positioning hole. Accordingly, each positioning pin also regulates the projecting distance of the corresponding joint pin from the main board, eliminating the need to separately provide a member for positioning a joint pin and a member for regulating the projecting distance of the joint pin, and hence simplifying the component structure. In addition, when the joint pins are soldered, their regulated distances make it possible to obtain a stable fillet shape with stable quality.

It should be noted that the shape of the outer frame of the power module, the shapes and arrangements of the joint pins and positioning pins, the shapes, of the small-diameter portions, large-diameter portions, and height regulating faces of the positioning pins are not limited to those described in the foregoing embodiments but various modifications may be made to them. For example, the positioning pins may have a square or L-shaped cross-section instead of a circular cross-section. Additionally, the positioning holes do not have to be through-holes but may have bottomed-holes. The auxiliary board joining structure of the present invention can be used in various electronic boards in which an auxiliary board is mounted on a main board using a through-hole mounting method.

The auxiliary board joining structure further includes a plurality of positioning holes (6) formed in the main board (1), a plurality of positioning pins (20) formed on the main board (1), wherein the plurality of positioning pins (20) extend through the corresponding positioning holes (6) so as to be oriented parallel to the axial direction of the joint pins (17). Each of the positioning pins (20) has a height regulating face (23) for regulating a distance that the positioning pins are extended through the corresponding positioning hole (6). Each of the positioning pins (20) is formed long enough to be extended through the corresponding positioning hole (6) before the joint pins (17) are extended through the corresponding through-holes (5), when the main board (1) and the auxiliary board (10) are engaged.

### Reference Signs List

- 1: print board (main board)
- 2: surface mounting device
- 5: through-hole
- 6, 6a: positioning hole
- 7: insertable component
- 10, 10a: power module (auxiliary plate)
- 11, 11a: outer frame
- 12: power module board
- 16: sealing resin
- 17: joint pin
- 20, 20a: positioning pin
- 21, 21a: small-diameter portion
- 22, 22a: large-diameter portion
- 23, 23a: height regulating face

## Claims

1. An auxiliary board joining structure comprising: a main board (1), an auxiliary plate (10, 10a), a joint pin (17) extending upward from the auxiliary board (10, 10a), and a through-hole (5) for the joint pin (17) formed in the main board (1), wherein the main board (1) and auxiliary board (10, 10a) are electrically and physically joined using a through-hole mounting system in which the joint pin (17) is extended through the through-hole (5), thereby soldering the main board (1) and auxiliary board (10, 10a), the auxiliary board joining structure further comprising:
a plurality of positioning holes (6, 6a) formed in one of the main board (1) and the auxiliary board (10, 10a);
a plurality of positioning pins (20, 20a) formed on the other one of the main board (1) and the auxiliary board (10, 10a), wherein the plurality of positioning pins (20, 20a) extend through the corresponding positioning holes (6, 6a) so as to be oriented parallel to the axial direction of the joint pins (17),
wherein each of the positioning pins (20, 20a) has a height regulating face (23, 23a) for regulating a distance that the positioning pin is extended through the corresponding positioning hole (6, 6a).

2. The auxiliary board joining structure according to claim 1, wherein each of the positioning pins (20, 20a) is formed long enough to be extended through the corresponding positioning hole (6, 6a) before the joint pins (17) are extended through the corresponding through-holes (5), when the main board (1) and the auxiliary board (10, 10a) are engaged.

3. The auxiliary board joining structure according to claim 1 or 2, wherein each of the positioning pins (20) has a large diameter portion (22, 22a) and a small-diameter portion (21, 21a) extending upward from an end face of the large-diameter portion, and wherein a step surface between the large diameter portion (22, 22a) and the small-diameter portion (21, 21a) serves as the height regulating face (23, 23a).

4. The auxiliary board joining structure according to any one of claims 1, 2, and 3, wherein the auxiliary board (10) includes a power module board (12) from which the joint pins (17) extend, and an outer frame (11) holding the power module board (12) via sealing resin (16); and wherein the positioning pin (20) is integrally formed on the outer frame (11).
